(19) **Europäisches Patentamt**

**European Patent Office**

**Office européen des brevets**

(11) **EP 1 289 082 A2**

(12) **EUROPEAN PATENT APPLICATION**

(43) Date of publication:
05.03.2003  Bulletin 2003/10

(51) Int Cl.⁷: **H01S 5/12**

(21) Application number: **02018693.8**

(22) Date of filing: **21.08.2002**

| | |
|---|---|
| (84) Designated Contracting States:<br>**AT BE BG CH CY CZ DE DK EE ES FI FR GB GR IE IT LI LU MC NL PT SE SK TR**<br>Designated Extension States:<br>**AL LT LV MK RO SI**<br><br>(30) Priority: **28.08.2001  JP 2001258167**<br><br>(71) Applicant: **THE FURUKAWA ELECTRIC CO., LTD.**<br>**Tokyo (JP)**<br><br>(72) Inventors:<br>• **Funabashi, Masaki,**<br>**The Furukawa Electric Co., Ltd.**<br>**Tokyo (JP)** | • **Yatsu, Ryosuke, The Furukawa Electric Co., Ltd.**<br>**Tokyo (JP)**<br>• **Kasukawa, Akihiko,**<br>**The Furukawa Electric Co., Ltd.**<br>**Tokyo (JP)**<br><br>(74) Representative: **Pätzold, Herbert, Dr.**<br>**Pätzold, Tandler, Riegger & Kollegen,**<br>**Steubstrasse 10**<br>**82116 Gräfelfing (DE)** |

(54) **Semiconductor laser device having selective absorption qualities over a wide temperature range**

(57)    A semiconductor laser device having a semiconductor substrate (12), an active region (16) formed on the semiconductor substrate (12) and configured to radiate light having a predetermined wavelength range, a light reflecting facet and a light emitting facet positioned at opposing longitudinal ends of the active region to form a resonant cavity. A diffraction grating (20) is positioned within the resonant cavity, and is configured to select a first portion of the radiated light for emitting from the semiconductor laser device, and an absorption region (20) located in a vicinity of the active region (16) and configured to selectively absorb a second portion of the radiated light, the first portion of the radiated light having a different wavelength than the second portion of the mediated light. The light emitting facet has a reflectivity value of aproximately in the range of 10% - 30%.

FIG. I

EP 1 289 082 A2

**Description**

BACKGROUND OF THE INVENTION

Field of the Invention

The present invention relates generally to semiconductor laser devices, and more particularly to a distributed feedback (DFB) semiconductor laser device having excellent single longitudinal-mode lasing characteristics over a relatively wide operating temperature of the laser device, and a good resistance to external optical feedback.

Discussion of the Background

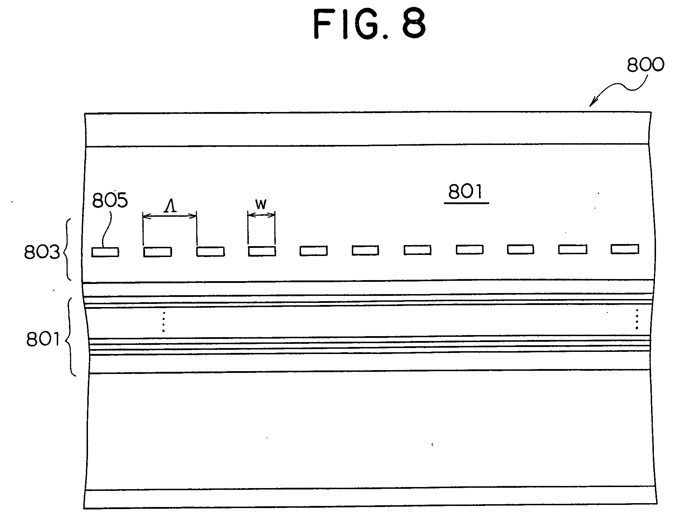

With the recent demand for increased bandwidth for data communications, optical networks and the components essential for their operation are being closely studied. To provide a light source for such optical networks, semiconductor laser devices such as the distributed feedback semiconductor laser device have been used. Figure 8 shows a cross section of an exemplary distributed feedback semiconductor laser 800 (hereinafter, referred to as a DFB laser). As seen in this figure, the DFB laser has an active layer 801 wherein radiative recombination takes place, and a diffraction grating 803 for changing the real part and/or the imaginary part of the refractive index (complex refractive index) periodically, so that only the light having a specific wavelength is fed back for wavelength selectivity. The diffraction grating 803 is comprised of a group of periodically spaced parallel rows of grating material 805 surrounded by a cladding material 807 (typically made of InP material) to form a compound semiconductor layer that periodically differs in refractive index from the surroundings. In a DFB laser having such a diffraction grating 803 in the vicinity of its active layer 801, the lasing wavelength $\lambda_{DFB}$ which is emitted from the DFB laser is determined by the relation:

$$\lambda_{DFB} = 2n_{eff}\Lambda,$$

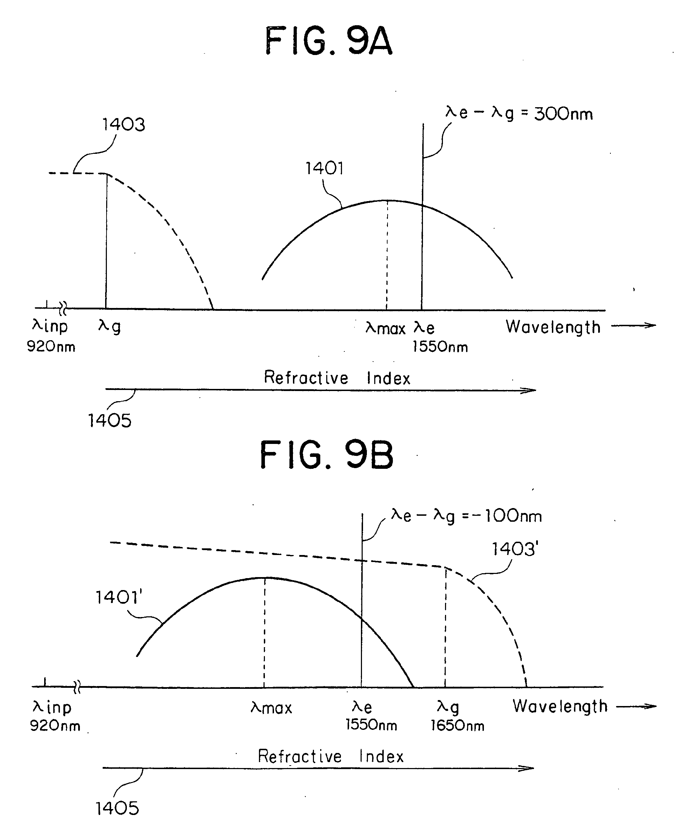

where $\Lambda$ is the period of the diffraction grating as shown in Figure 8, and $n_{eff}$ is the effective refractive index of the waveguide. Thus, the period $\Lambda$ of the diffraction grating and the effective refractive index $n_{eff}$ of the waveguide can be adjusted to set the lasing wavelength $\lambda_{DFB}$ independent of the peak wavelength of the optical gain of the active layer.
This setting of the lasing wavelength $\lambda_{DFB}$ independent of the peak wavelength of the optical gain of the active layer allows for essential detuning of the DFB laser device. Detuning is the process of setting the emitted lasing wavelength of a laser to a different value than the peak wavelength of the optical gain of the active layer to provide more stable laser operation over temperature changes. As is known in the art, a moderately large detuning value (that is, a large wavelength difference between the emitted lasing wavelength and the peak wavelength of the optical gain of the active layer) can improve high speed modulation or wide temperature laser performance, while too large a detuning amount degrades performance. The present inventors have recognized that the amount of detuning changes over wide temperature range because temperature dependence on the lasing wavelength is about 0.1nm/C, while the gain peak wavelength changes at about 0.4nm/C. Thus, for wide temperature operation, reduction of optical gain especially in the high temperature range should be carefully considered in designing the detuning.
In addition to detuning, the lasing wavelength $\lambda_{DFB}$ may also be set independent of the peak wavelength of the optical gain of the active layer in order to the obtain different characteristics of the semiconductor laser device. For example, when the lasing wavelength of the DFB laser is set at wavelengths shorter than the peak wavelength of the optical gain distribution, the differential gain increases to improve the DFB laser in high-speed modulation characteristics and the like. Where the lasing wavelength of the DFB laser is set approximately equal to the peak wavelength of the optical gain distribution of the active layer, the threshold current of the laser device decreases at room temperature. Still alternatively, setting $\lambda_{DFB}$ at wavelengths longer than the peak wavelength improves operational characteristics of the DFB laser, such as output power and current injection characteristics, at higher temperatures or at a high driving current operation.
The conventional DFB laser such as that disclosed in Figure 8 can be broadly divided into a refractive index coupled type laser and a gain coupled type laser. In the refractive index coupled DFB laser, the compound semiconductor layer constituting the diffraction grating has a bandgap energy considerably higher than the bandgap energy of the active layer and the bandgap energy of the lasing wavelength. Thus, bandgap wavelength (which is a wavelength conversion of the bandgap energy) of the diffraction grating is typically at least 100 nm shorter than the lasing wavelength and is usually within the range of 1200 nm - 1300 nm if the $\lambda_{DFB}$ is approximately 1550nm. In the gain coupled DFB laser, the bandgap wavelength of the compound semiconductor layer constituting the diffraction grating is longer than the lasing wavelength and is typically about 1650nm if the $\lambda_{DFB}$ is approximately 1550nm. Figures 9a and 9b show the operational characteristics of an exemplary refractive index coupled laser and gain coupled laser respectively.

Each of these figures includes λe, λg, λmax, and λInP shown plotted on an abscissa which shows wavelength increasing from left to right in the figures. In this regard, λe is the selected lasing wavelength of the DFB laser 800, λmax is the peak wavelength of the optical gain distribution of the active layer 801, λg is the bandgap wavelength of the diffraction grating material 805, and λInP is the bandgap wavelength of the surrounding InP material 807. As seen in Figures 9a and 9b, the bandgap wavelength λInP is typically 920 nm and the bandgap wavelength λg is closely related to the absorption loss of the diffraction grating which is shown by the broken curves 903 and 903'. Moreover, the refractive index of a material increases as the bandgap wavelength of the material increases as shown by the arrows 905. Thus, as seen in the figures, the refractive index of the diffraction grating having the bandgap wavelength λg is generally higher than the refractive index of the surrounding Inp layer having the bandgap wavelength λInP.

Figure 9a shows an exemplary refractive index coupled DFB laser wherein the DFB laser has a lasing wavelength λe of 1550 nm and bandgap wavelength λg of 1250 nm, and satisfies the relationship:

$$\lambda g < \lambda e.$$

Thus, the DFB laser of Figure 9(a) reflects λe - λg = 300 nm. The DFB lasing wavelength λe is usually set within the several tens of nanometer range from the peak wavelength λmax of the optical gain distribution of the active layer. In the Figure 9(a), λe is located longer than λmax. With the refractive index coupled DFB laser, the absorption loss curve 903 does not cross the lasing wavelength λe and therefore absorption loss at λe is very small. Accordingly, the DFB laser of Figure 9a, has the advantage of a low threshold current and favorable optical output-injection current characteristics. However, as also shown in Figure 9a, in a refractive index coupled DFB laser, the absorption loss curve 903 also does not cross the peak wavelength of the optical gain distribution of the active layer λmax. Therefore, assuming that the absorption coefficient with respect to the lasing wavelength λe of the DFB laser is αe and the absorption coefficient with respect to the bandgap wavelength of the active layer, or the peak wavelength λmax of the optical gain distribution of the active layer, is αmax, then αe is approximately equal to αmax which is approximately equal to zero. This means that the absorption curve 903 affects neither λmax nor λe, and the peak wavelength λmax of the optical gain distribution of the active layer is not suppressed with respect to the lasing wavelength λe.

More specifically, there is a problem with the refractive index coupled laser in that a side mode suppression ratio (SMSR) of adequate magnitude cannot be secured between the lasing mode at the designed lasing wavelength λe of the DFB laser and the mode around the peak wavelength λmax of the optical gain distribution of the active layer. In addition, because neither the λmax nor the λe wavelengths are affected by the absorption curve 903, wide detuning cannot be accomplished using the refractive index coupled semiconductor laser of Figure 9a. That is, the absolute value of the detuning amount |λe - λmax| cannot be made greater since an increase in the absolute value of the detuning amount |λe - λmax| would result in a large gain difference between the lasing wavelength λe and λmax, and lowers the single mode properties and narrows the temperature range operation of the refractive index coupled semiconductor laser.

Finally, with the refractive index coupled DFB laser of Figure 9a, the difference in the refractive index of the grating material 805 and the refractive index of the InP buried layer 807 is relatively small. Therefore, the physical distance between the grating material 805 and the active layer 801 of the DFB laser 800 must be reduced and, as a result, the coupling coefficient varies greatly depending on the thickness of the diffraction grating layer and the duty ratio which is expressed as W/Λ, where W is the width of one element of the diffraction grating and Λ is the pitch of the gratings. This makes it difficult to fabricate refractive index coupled DFB laser devices having the same characteristics resulting in low manufacturing yields for this type of laser.

As seen in Figure 9b, the gain coupled DFB laser has a lasing wavelength λe of which is less than the bandgap wavelength λg of the diffraction grating layer. Specifically, the DFB laser of Figure 9b has a lasing wavelength λe of 1550 nm, a bandgap wavelength λg of 1650 nm, and satisfies the relationship:

$$\lambda e < \lambda g.$$

Thus, this exemplary DFB laser reflects λe - λg = -100 nm. in the gain coupled DFB laser of Figure 9b, there is a relatively large difference between the refractive index of the grating material 805 and refractive index of the InP buried layer 807 which makes it possible to increase the distance between the grating material 805 and the active layer 801. As a result, unlike the refractive index coupled DFB laser, the coupling coefficient of the gain coupled laser is hard to vary with the thickness of the diffraction grating layer and the duty ratio, and same-characteristic DFB lasers can be fabricated with stability thereby allowing higher production yields for this type of laser.

However, as also seen in Figure 9b, the gain coupled DFB laser has an absorption loss curve 903' that crosses the lasing wavelength λe and, therefore, absorption loss at the desired lasing wavelength λe is large resulting in a high threshold current and unfavorable optical output-injection current characteristics. Moreover, although the absorption loss curve 903' also crosses the undesired wavelength of $\lambda$max, the absorption coefficient $\alpha$max is approximately equal to the absorption coefficient $\alpha$e. That is, as with the refractive index coupled DFB laser, the absorption curve 903' of the gain coupled DFB laser affects $\lambda$max and $\lambda$e equally and the peak wavelength $\lambda$max of the optical gain distribution of the active layer is not suppressed with respect to the lasing wavelength $\lambda$e resulting in a low side mode suppression ratio (SMSR). For example, in the conventional DFB lasers of Figures 9a and 9b, the SMSR, though depending on the amount of detuning to the lasing wavelength of the DFB laser, falls within a comparatively small range of 35 and 40 dB. Also like the refractive index coupled DFB laser, since the absorption curve 903' affects $\lambda$max and $\lambda$e equally, wide detuning cannot be accomplished because the wider the spacing between the $\lambda$max and $\lambda$e wavelengths, the smaller the gain of the desired lasing wavelength $\lambda$e will be with respect to the undesired $\lambda$max. Thus, whether the $\lambda$e is set shorter or longer than $\lambda$max, the absolute value of the detuning amount $|\lambda$e - $\lambda$max$|$ of conventional refractive index and gain coupled DFB lasers is limited several tens of nanometers thereby causing unfavorable single mode and temperature range characteristics for these devices.

As noted above, conventional refractive index coupled and gain coupled DFB laser devices have poor SMSR and cannot achieve wide detuning thereby allowing the DFB laser device to lase in a Fabry-Perot mode at the peak wavelength $\lambda_{max}$ rather than the designed emission wavelength $\lambda_e$. The present inventors have discovered that this problem of degradation of the single-longitudinal-mode characteristic is especially noticeable when the DFB laser device operates in a wider temperature range of -40 and +85 degrees C, for example. In general, if the operating temperature of the DFB laser device changes, a change occurs in the amount of difference between the peak wavelength $\lambda_{max}$ and the emission wavelength $\lambda_e$. Thus, the absolute value of the detuning amount $|\lambda_e-\lambda_{max}|$ is difficult to maintain within an allowable range in the wide temperature range.

More specifically, the present inventors have discovered that, in a DFB laser device using an InGaAsP-based semiconductor material, the temperature dependence of the peak wavelength $\lambda_{max}$ is around 0.4 nm/degree C, whereas the temperature dependence of the emission wavelength $\lambda_c$ is around 0.1 nm/degree C. Thus, if the DFB laser device operates in the range between -40 and +85 degrees C, the detuning amount $\lambda_e-\lambda_{max}$ changes by about 40 nm in the temperature range, by the following calculation:

$$(0.4\text{-}0.1)\times(85\text{-}(\text{-}40)) = 37.5 \text{ nm.}$$

Therefore, if the detuning amount is designed at 0nm (thereby allowing the DFB laser device to lase at the peak wavelength $\lambda_{max}$) at a temperature of +85 degrees C for example, at which temperature the optical gain of the DFB laser device is generally low, the detuning amount can assume as high as +40nm at a lower temperature of -40 degrees C. This detuning amount of +40nm causes the conventional DFB laser device to lase at the peak wavelength $\lambda_{max}$ in the Fabry-Perot mode, i.e., not at the design emission wavelength $\lambda_e$ for the DFB laser device, thereby preventing the DFB laser device from operating in the single-longitudinal-mode. Therefore, in order to achieve an excellent single-longitudinal-mode characteristic or an excellent modulation characteristic in the whole temperature range of the DFB laser device, the detuning amount should be precisely maintained within a specified range at least at a specified temperature, such as the room temperature.

Prior art devices have attempted to achieve good single mode operation over a wide detuning range by suppressing the Fabry-Perot mode lasing using a low reflectivity at one of the facets of the DFB laser device. This low reflectivity is achieved by a non-reflection coating, and is generally adopted at the emission facet of the DFB laser device in order to maintain emission efficiency. The present inventors have discovered, however, that the lower reflectivity at the emission facet has a problem in that the DFB laser device suffers from a lower resistance against the external optical feedback because the light reflected from outside the cavity is likely to enter the resonant cavity of the DFB laser device through the low reflectivity emission facet. The external reflection light into the resonant cavity affects the lasing operation to generate noise and thus renders the DFB laser device unstable.

SUMMARY OF THE INVENTION

Accordingly, one object of the present invention is to provide a semiconductor laser device and method which overcomes the above described problems.

Another object of the present invention is to provide a reliable technique that effectively suppresses the Fabry-Perot mode lasing to obtain a stable operation of the DFB laser device and suppresses the degradation in the resistance against the external optical feedback for a laser device having a larger detuning amount.

According to a first aspect of the invention, there is provided a semiconductor laser device having a semiconductor substrate, an active region formed on the semiconductor substrate and configured to radiate light having a predetermined wavelength range, a light reflecting facet and a light emitting facet positioned at opposing longitudinal ends of the active region to form a resonant cavity. A diffraction grating is positioned within the resonant cavity, and is configured to select a first portion of the radiated light for emitting from the semiconductor laser device, and an absorption region located in a vicinity of the active region and configured to selectively absorb a second portion of the radiated light, the first portion of the radiated light having a different wavelength than the second portion of the radiated light. The light emitting facet has a reflectivity value of aproximately in the range of 10% - 30%.

In one embodiment of the first aspect, the first portion of the radiated light is a single mode lasing wavelength $\lambda e$ and the second portion of the radiated light is a peak wavelength $\lambda_{max}$ of an optical gain distribution of the active region. In this embodiment, the absorption region is configured to provide operational characteristics satisfying any one of the relationships: $0 < \lambda e - \lambda_{abs} \leq 100$ nm or $0 < \lambda e - \lambda_{abs} \leq 70$ nm, where $\lambda_{abs}$ is the bandgap wavelength of the absorption region, and $\lambda e$ is the single mode lasing wavelength.

In another embodiment of the first aspect, the absorption region of the semiconductor laser is configured to provide operational characteristics satisfying any one of the relationships: $\alpha_{max} > \alpha e$; $\alpha_{max} - \alpha e \geq 1$ cm$^{-1}$; or $\alpha_{max} - \alpha e \geq 5$ cm$^{-1}$, in terms of waveguide loss, where $\alpha_{max}$ is an absorption coefficient with respect to the peak wavelength $\lambda_{max}$ of the optical gain distribution of the active region, and $\alpha e$ is an absorption coefficient with respect to the selected lasing wavelength $\lambda e$. In this embodiment, the absorption region may be configured such that the absorption coefficient $\alpha e$ is substantially 0.

In yet another embodiment of the first aspect of the present invention, the active region, wavelength selecting structure, and absorption region are configured to provide operational characteristics satisfying any one of the relationships $\lambda_{abs} < \lambda_{max} < \lambda e$, or the relationship $\lambda_{max} < \lambda_{abs} < \lambda e$, where $\lambda_{abs}$ is the bandgap wavelength of the absorption region, $\lambda_{max}$ is the peak wavelength of an optical gain distribution of the active region, and $\lambda e$ is the single mode lasing wavelength.

The absorption region may be provided by the diffraction grating or a selective absorption semiconductor layer. Moreover, the light emitting facet may be approximately in the range of 10-20%, or approximately equal to 10%. Also, the light reflecting facet may be approximately 90%.

BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:

Figure 1 is a partially sectional perspective view showing the structure of a semiconductor layer device according to a first embodiment of the present invention;
Figure 2 is a sectional view of the semiconductor laser device taken along the arrowed line I-I of Figure 1;
Figures 3a and 3b are a wavelength graphs showing the operational characteristics of DFB laser devices according to the first embodiment of the present invention.
Figures 4(a)- 4(e) are sectional views depicting the steps of fabricating the semiconductor laser device according to the first embodiment of the present invention;
Figure 5 is a partially sectional perspective view showing the structure of a semiconductor laser device according to a second embodiment of the present invention;
Figure 6 is a sectional view of the semiconductor laser device taken along the arrowed line III-III of Figure 5.
Figure 7 is a wavelength graph showing the operational characteristics of DFB laser devices according to the second embodiment of the present invention;
Figure 8 is a cross section view of a conventional DFB laser device; and
Figures 9a and 9b are wavelength graphs showing the operational characteristics of conventional refractive index coupled and gain coupled DFB lasers.

DETAILED DESCRIPTION OF THE PREFERRED EMBODIMENTS

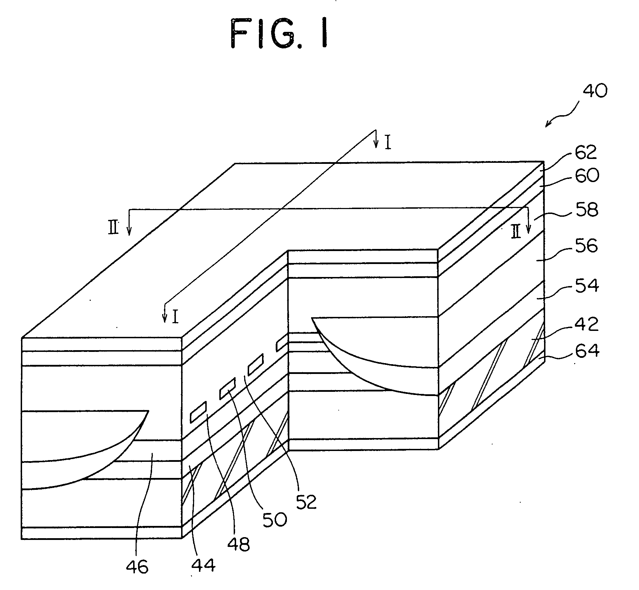

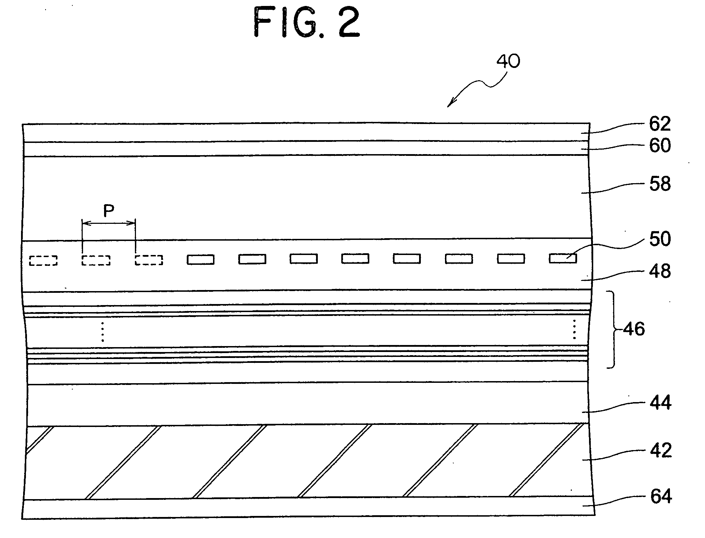

Referring now to the drawings wherein like elements are represented by the same or similar reference designations throughout, and more particularly to Figures I and 2, there is shown a semiconductor laser device 40 for providing selective light absorption in accordance with a first embodiment of the present invention. Figure 1 is a partially sectional perspective view showing the structure of a semiconductor laser device according to the first embodiment of the present invention, and Figure 2 is a sectional view of the semiconductor laser device taken along the arrowed line I-I of Figure 1.

The semiconductor device of Figures 1 and 2 is a buried hetero-junction type DFB laser device including an n-InP substrate 42 having a 1-μm-thick n-InP buffer layer 44, an active layer or active region 46, and a 200-nm-thick p-InP spacer layer 48 sequentially stacked on the substrate 42. Buffer layer 44 serves both as a buffer layer by the n-InP material and a under cladding layer, while the active layer 46 is a separate confinement multiple quantum well (SCH-MQW) structure. As best seen in Figure 2, a diffraction grating 50 of a GaInAsP material is periodically formed within the p-InP spacer layer 48 substantially along the entire length of active layer 46. However, the diffraction grating 50 may be formed over a portion of the entire length of active layer 46 as shown by the phantom grating material in Figure 2. The diffraction grating 50 of the embodiment of Figures 1 and 2 has a film thickness "th" of 20 nm, a period "A of 240 nm, and selects a laser beam having a lasing wavelength of 1550 nm to be emitted by the semiconductor laser device 40.

A top portion of the n-InP substrate 42, the n-InP buffer layer 44, the active layer 46, and the p-InP spacer layer 48 having the diffraction grating 50 buried therein form a laminated structure which is etched into mesa stripes so that the active layer 46 has a width of approximately 1.5 μm. Current block structures each including a p-InP layer 54 and an n-InP layer 56 are formed on both sides of the mesa stripes. The DFB laser device 40 also has a 2-μm-thick p-InP upper cladding layer 58 and a heavily doped p-GaInAs contact layer 60 sequentially stacked on the spacer layer 48 and blocking layers. Also included is a p-side electrode 62 made of a Ti/Pt/Au laminated metal film over the contact layer 60, and an n-side electrode 64 made of AuGeNi on the bottom surface of the substrate 42.

It is to be understood that the device of Figures 1 and 2 is for exemplary purposes only as many variations of the structure of the laser device 40 will be readily apparent to one having ordinary skill in the art. For example, the material composition and layer thicknesses described may be changed without deviating from the principles of the present invention. Thus, the embodiment of Figures 1 and 2 are exemplary for a better understanding of the present invention and the present invention is not limited to these illustrations.

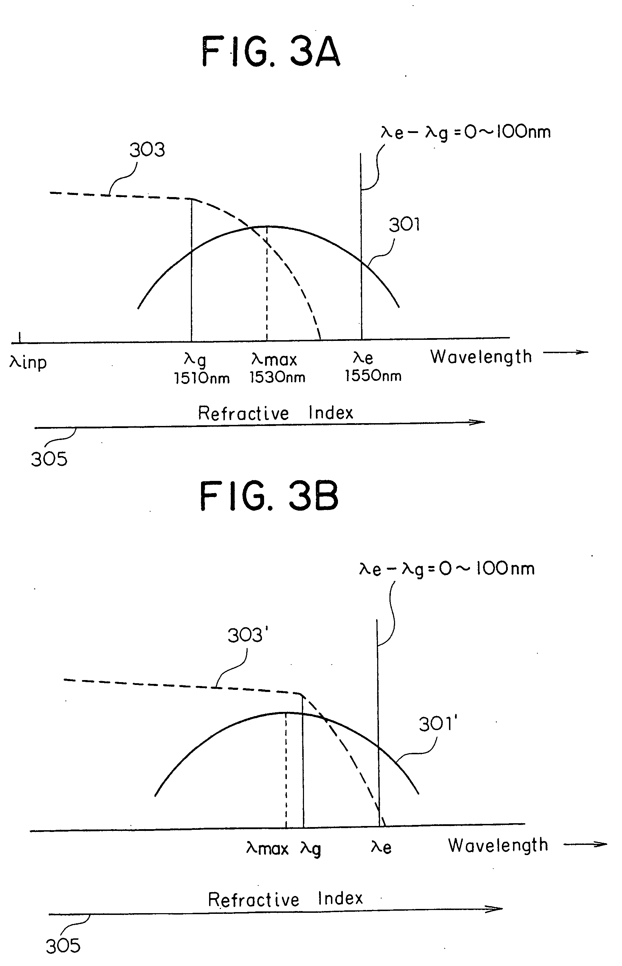

In order to evaluate the DFB laser device 40, wafers having the laminated structure of Figures 1 and 2 were subjected to coating the front facet to form a low-reflective film of about 10% and at the rear facet to form a high-reflectance film of about 90%, and measured for the laser characteristics thereof. Based on these measurements, Figure 3a shows exemplary operational characteristics of a DFB laser according to the embodiment of Figures 1 and 2 of the present invention. As seen in Figure 3a, the DFB laser 40 has a lasing wavelength $\lambda e$ of approximately 1550 nm, and the diffraction grating 50 has a bandgap wavelength $\lambda g$ of approximately 1510 nm, and a $\lambda_{max}$ of 1530nm at a temperature of 25 degrees C. In a preferred embodiment, GaInAsP having a $\lambda_g$ of approximately 1510 nm is used to form the diffraction grating 50. Thus, the difference in the lasing wavelength and the bandgap wavelength of the diffraction grating in Figures 1 and 2 is approximately 40 nm. More generally, a laser device in accordance with the present invention reflects a difference $\lambda e - \lambda g$ of between 0 and 100 nm as noted in Figure 3a ($\lambda e - \lambda g = 0 \sim 100nm$). Moreover, the peak wavelength $\lambda$ of the active layer 46 is approximately 1530 nm in the optical gain distribution curve 301. Therefore the DFB laser of Figure 3a satisfies the relationship:

$$\lambda g < \lambda_{max} < \lambda e.$$

As with the prior art figures discussed in the Background section above, Figure 3a depicts an absorption curve 303 as well as an arrow 305 showing the refractive index of the grating material 50 and the active layer 46. The present inventors have discovered that the a DFB laser of Figures 1 and 2 having the operational characteristics of Figure 3a provides several advantages over the prior art DFB lasers.

First, the semiconductor laser device of Figures 1 and 2 provides selective absorption of the undesirable peak gain wavelength $\lambda_{max}$. As described above, the bandgap wavelength of a material is closely related to the wavelength absorption characteristics of the material. Thus, in the embodiment of Figures 1 and 2, the diffraction grating material 50 is selected to have a bandgap wavelength $\lambda g$ that will provide an absorption curve 303 that crosses the peak wavelength $\lambda_{max}$ but does not cross the lasing wavelength $\lambda e$. That is, the absorption at wavelength $\lambda e$ is preferably 0. More generally, however, according to the embodiment of Figures 1 and 2, the diffraction grating is constructed such that an absorption coefficient $\alpha_{max}$ is greater than an absorption coefficient $\alpha e$. For example, the diffraction grating 50 is preferably constructed such that $\alpha_{max} - \alpha e$ is greater than or equal to 1cm$^{-1}$ in terms of waveguide loss, and more preferably greater than or equal to or equal to 5cm$^{-1}$ in terms of waveguide loss.

It is preferable that the relationship $\alpha_{max} > \alpha_e$ hold for the whole operating temperature range of the DFB laser. However, it is sufficient that the relationship $\alpha_{max} > \alpha_e$ hold in a part of the operating temperature range, such as a lower temperature range below zero degree C. In such a case, the DFB laser device can suppress the Fabry-Perot lasing at around $\lambda_{max}$ in the lower temperature range.

In addition, by providing such selective absorption of the peak wavelength $\lambda_{max}$, a laser device of Figures 1 and 2 simultaneously provides the benefits of both the refractive index coupled and the gain coupled DFB lasers described in the Background section above. That is, as with the refractive index coupled DFB laser described in Figure 9a, the selective absorption loss curve 303 of the present invention does not cross the lasing wavelength $\lambda e$. Therefore, the absorption loss at $\lambda e$ is very small and the DFB laser depicted in Figure 3a has a low threshold, and favorable optical output-injection current characteristics and higher output power. Specifically, the lasing efficiency of the present invention was compared with that of the conventional type DFB laser devices, revealing that the absorption with respect to the lasing wavelength of the diffraction grating 50 was sufficiently lower, and that the threshold current was as low as 9 mA in the present embodiment.

Moreover, as with the gain coupled DFB laser described in Figure 9b, the laser having the characteristics of Figure 3a has a relatively large difference between the refractive index of the grating material 50 and refractive index of the InP buried layer 48. In a practical exemplification, the diffraction grating 20 has a refractive index of 3.49 whereas the embedding InP layer 22 has a refractive index of 3.17, whereby the difference in the refractive index is as large as 0.32. Although a larger difference is preferable, 0.25 or above should be adopted in a practical view point. As mentioned, this makes it possible to vary the duty ratio and increase the distance between the grating material 50 and the active layer without varying the coupling coefficient of the laser device of the present invention. Therefore, even if the p-InP spacer layer 48 is increased in thickness to separate the diffraction grating 50 away from the active layer 46, it is possible to obtain a diffraction grating coupling coefficient of adequate magnitude. Accordingly, the tolerance in the crystal growing process of the fabrication process is alleviated to allow higher production yields of a laser device in accordance with the present invention.

The DFB laser device of Figures 1 and 2 provides advantages not offered by either of the conventional laser devices described above. First, since the DFB laser 40 according to the present invention selectively absorbs the peak wavelength $\lambda_{max}$, the side mode suppression ratio (SMSR) is significantly better than that of the prior art devices. Specifically, the DFB laser device 40 was found to have stable single mode lasing characteristics and offered a side mode suppression ratio as large as 45-50 dB. As mentioned above, conventional DFB laser devices offered a SMSR generally limited to around 35-40 dB. Moreover, because the selective absorption of the invention of Figures 1 and 2 provides an absorption of $\lambda_{max}$ that is greater than the absorption of $\lambda e$, wide detuning can be accomplished using the semiconductor laser of Figure 3a. That is, the absolute value of the detuning amount $|\lambda e - \lambda_{max}|$ can be made greater since the selective absorption and high SMSR can be used to maintain single-mode properties of the longitudinal mode and suppress the gain at the peak wavelength $\lambda_{max}$. In this regard, it is noted that, by way of the present invention, the present inventors have discovered a device which can achieve wide detuning and can also be manufactured with high production yields due to the spacing between the active and grating layers as described above. Finally, since wide detuning can be achieved, the semiconductor laser device according to the present invention can provide high output power over a wide temperature range. Thus, the semiconductor laser of the first embodiment can maintain favorable single mode properties even though detuning is increased.

More specifically, the tested samples having the structure of Figures 1 and 2 exhibited a threshold current of about 26 mA and had a detuning amount around zero nm at a high temperature of 85 degrees C. The samples also had a detuning amount of about +40nm at a lower temperature of -40 degrees C, and exhibited an excellent single mode yield of 85% even with the relatively high reflectivity of 10% adopted at the emission facet. This is considered due to the suppression of the Fabry-Perot mode lasing by the function of the diffraction grating 20 selectively absorbing the vicinity of the peak wavelength $\lambda_{max}$. Moreover, the reflectivity of 10% at the emission facet provides a higher optical output power of 0.32 watts/ampere and a higher resistance to external feedback noise. Thus, the laser device having the structure of Figures 1 and 2 provides good single mode operation over a wide detuning range, while maintaining good resistance to noise caused by external feedback. That is, in the present invention, even if the absolute value of the detuning amount $|\lambda_c-\lambda_{max}|$ changes depending on the operating temperature to assume a value more than 40nm at the maximum thereof, the DFB laser device has an excellent single-longitudinal-mode characteristic or an excellent modulation characteristic. Moreover, the DFB laser operates at a high optical output power and has an excellent resistance against the external optical feedback.

More generally, the present inventors conducted experiments on a plurality of specimens for each of six samples of the DFB laser device of Fig. 2. Each specimen had a reflectivity of 1% (first sample), 5% (second sample), 10% (third sample), 20% (fourth sample), 30% (fifth sample) or 50% (sixth sample) at the emission facet, and a reflectivity of 90% (first to sixth samples) at the rear facet on the samples were coated with a high reflection coat, except for the fifth sample having a reflectivity of 30%, which was an as-cleaved emission facet wherein the emission facet is not coated. The samples having the respective reflectivities were subjected to measurements or calculations of the optical output efficiency (watts/ampere), the product yield (%) with respect to the single mode characteristic ("single mode yield"), the product yield (%) with respect to the resistance against the external optical feedback ("resistance yield"), and the overall product yield. In this regard, the term "single mode yield" as used herein means the ratio of number of specimens of DFB laser having a SMSR of 35 dB or more in the whole temperature range between -40 and +85 degrees with respect to the total number of the specimens having a SMSR of 35 dB or more at 25 degrees C. Moreover, the term "resistance yield" as used herein means the number of specimens of DFB laser having a relative intensity noise (RIN) of -120 dB/Hz or less with respect to the total number of the specimens, in the case that external reflection has an intensity of -15 dB, or about 3% of the intensity of the original laser. Finally, the term "overall yield" means the product of the single mode yield and the resistance yield.

The results are shown in Table 1 as follows.

Table 1

| Sample No. | reflectivity | efficiency (W/A) | single mode yield | resistance yield | overall yield |
|---|---|---|---|---|---|
| 1 | 1 % | 0.37 | 95% | 18 % | 17.1% |
| 2 | 5 | 0.34 | 91 | 50 | 45.5 |
| 3 | 10 | 0.32 | 85 | 80 | 68.0 |
| 4 | 20 | 0.30 | 77 | 86 | 66.2 |
| 5 | 30 | 0.28 | 68 | 90 | 61.2 |
| 6 | 50 | 0.25 | 45 | 98 | 44.1 |

Based on these experiments, the present inventors discovered that a larger reflectivity of the emission facet reduces the optical output efficiency and the single mode yield, but increases the resistance yield. Moreover, the overall yield obtained by multiplication of the single mode yield by the resistance yield has a higher value in the range of the reflectivity of the emission facet between 10% and 30%. Finally, it was discovered that the range of reflectivity of the emission facet should reside between 10% and 20% for obtaining an optical output efficiency of 0.3 watts/ampere or higher.

While the above description provides an example of a DFB laser device having a $\lambda_g$ less than both $\lambda_c$ and $\lambda_{max}$, an absorption coefficient $\alpha_{max}$ greater than the absorption coefficient $\alpha e$ can also be achieved by setting the bandgap wavelength $\lambda_g$ of the diffraction grating 50 to a value between the peak wavelength of the optical gain distribution and the lasing wavelength 1550 nm of the DFB laser 40 as shown in Figure 3b. While these characteristics realize the benefits of the present invention, the absorption caused by the tails of the band edges also occurs on the lasing wavelength $\lambda_c$ as seen in Figure 3b. Thus, the threshold current increases and the lasing efficiency decreases, which is generally undesirable. It is to be noted, however, that the concept of selective absorption is not limited to selectively absorbing $\lambda_{max}$. Thus, if $\lambda_g<\lambda_{max}<\lambda_c$ holds, as shown in Fig. 3A, an excellent temperature characteristic can be obtained, whereby the DFB laser device achieves a higher optical output power at a higher temperature range or a higher injection current range. For example, if $\lambda_e-\lambda_{max}=20nm$, the difference between $\lambda_e$ and $\lambda_g$ may be set for satisfying the relationship $\lambda_e-\lambda_g=40nm$. On the other hand, if $\lambda_{max}<\lambda_g<\lambda_c$ holds, then the absorption coefficient $\alpha_{max}$ for the peak wavelength can be set at a larger value, whereby a Fabry-Perot lasing can be suppressed. In this case, for example, $\lambda_e-\lambda_{max}$ may be set at 30nm, whereas $\lambda_g-\lambda_{max}$ may be set between 10nm and 20nm.

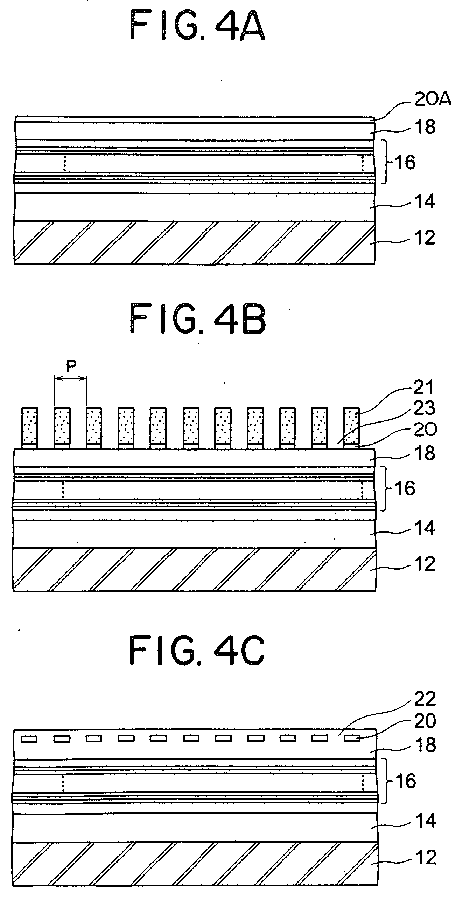

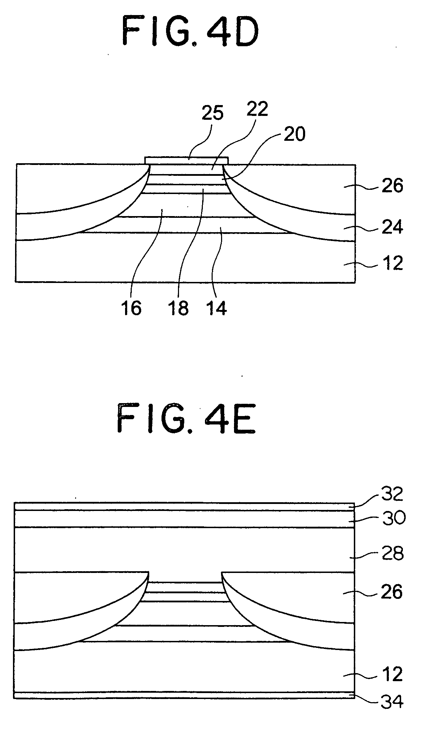

Figures 4a -4e are sectional views showing the method steps of fabricating the DFB laser device 40 of Figures 1 and 2 of the present invention. Figures 4a-4c show cross sections taken along the arrowed line I-I of Figure 1, while Figures 4d and 4e show cross sections taken along the arrowed line II-II of Figure 1.

As seen in Figure 4a, the process begins with an n-InP substrate 12 on which a 1-μm-thick n-InP buffer layer 14, MQW-SCH active layers 16, a 200-nm-thick p-InP spacer layer 18, and a 20-nm-thick GaInAsP diffraction grating layer 20A are sequentially stacked. Each layer is epitaxially grown on an n-InP substrate 12 in succession, in a metal-organic chemical vapor deposition (MOCVD) system at a growth temperature of 600°C to form the laminated structure shown in Figure 4a. An electron beam (EB) resist is applied on the diffraction grating layer 20A with a thickness of approximately 100 nm and the resist layer is patterned according to conventional techniques to form a diffraction grating pattern 21 having a period Λ of approximately 240 nm. Thereafter, etching is performed in a dry etching system with the diffraction grating pattern 21 as the mask, whereby trenches 23 penetrating the diffraction grating layer 20A are formed to expose the p-InP spacer layer 18 at the trench bottoms. This forms a diffraction grating 20 as shown in Fig. 4b.

The diffraction grating pattern 21 is then removed, and, as shown in Fig. 4c, a p-InP first cladding layer 22 to bury the diffraction grating 20 is re-grown in the MOCVD system. Thereafter, a SiN$_x$ film is formed over the p-InP first cladding layer 22 in a plasma CVD system. Then, using a photolithography and reactive ion etching system (RIE), the SiN$_x$ film is processed into a stripe to form a SiN$_x$ film mask 25 as seen in Figure 4d. Subsequently, using the SiN$_x$ film mask 25 as the etching mask, the p-InP first cladding layer 22 including the diffraction grating 20, the p-InP spacer layer 18, the active layer 16, the n-InP buffer layer 14, and a top portion of the n-InP substrate 12 are etched into mesa stripes with an active layer width of the order of 1.5 μm. Then, using the SiN$_x$ film mask 25 as the selective growth mask, a p-InP layer 24 and an n-InP layer 26 are selectively grown in succession. This forms current block structures on both sides of the mesa stripes as shown in Figure 4d.

Next, the SiN$_x$ film mask 25 is removed before a 2-μm-thick p-InP second cladding layer 28 and a contact layer 30, or a GaInAs layer that is heavily doped to make an ohmic contact with a p-side electrode 32, are epitaxially grown as shown in Fig 4E. The n-InP substrate 12 is polished at its bottom surface to a substrate thickness of on the order of 120 μm. Then, a Ti/Pt/Au laminated metal film is formed as the p-side electrode 32 over the contact layer 30.

On the bottom surface of the substrate is formed an AuGeNi film as an n-side electrode 34.

The wafer having the above-described laminated structure can be cleaved into a chip before coating the emission facet with a reflection coat having a reflectivity of 10% and the rear facet with a reflection coat having a reflectivity of 90%, and bonded by die bonding and wire-bonding to form the DFB laser device shown in Figures 1 and 2. As mentioned above, by using a material for diffraction grating 20 that has a bandgap wavelength close to that of the active layer material 16, the difference in refractive index of the diffraction grating 20 and the surrounding InP layer 22 is increased. This allows a desired refractive index coupling coefficient to be obtained even if the diffraction grating 20 is separated farther from the active layer 16 than in the conventional DFB laser devices. Accordingly, the tolerance in the crystal growing process and in the fabrication process of Figures 4a-4d is eased to allow stable crystal growth.

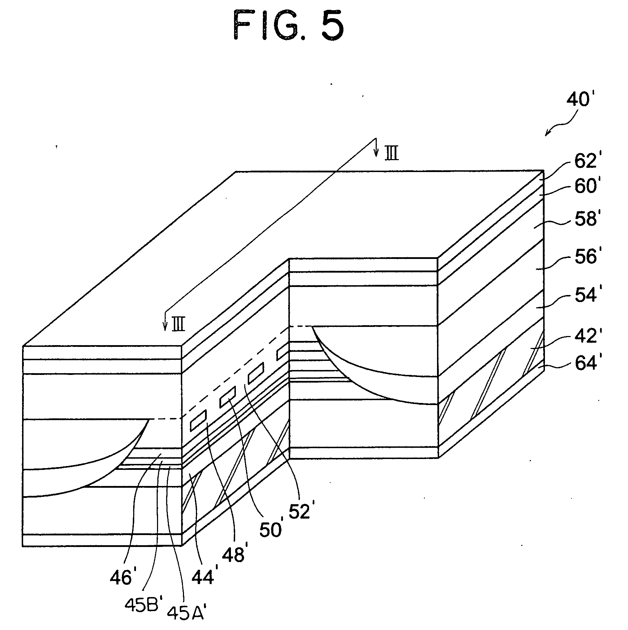

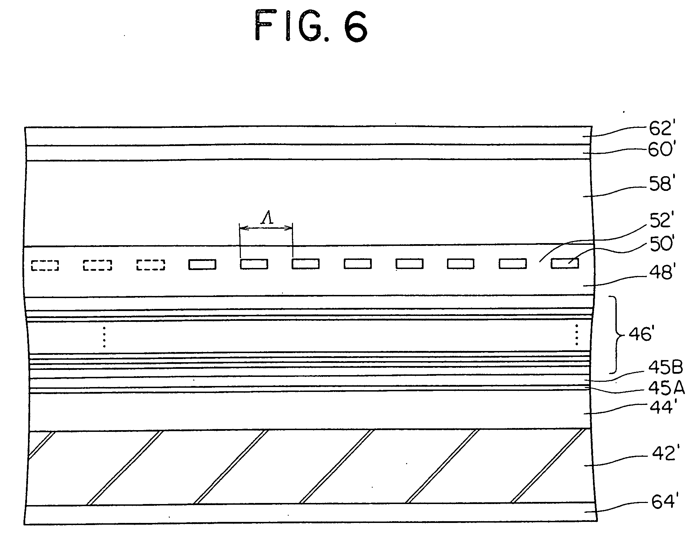

Figures 5 and 6 show a semiconductor laser device in accordance with a second embodiment of the present invention. Figure 5 is a partially sectional perspective view showing the structure of a semiconductor laser device according to the second embodiment of the present invention, and Figure 6 is a sectional view of the semiconductor laser device taken along the arrowed line III-III of Figure 5. In the DFB laser device 40 of the embodiment 1, the absorption region of the laser device is provided in the diffraction grating 20. On the other hand, the semiconductor laser device 40' of the second embodiment, though constituted likewise as a buried hetero-junction type DFB laser device with the designed lasing wavelength of 1550 nm, includes a selective absorption layer 45A, aside from the diffraction grating for selectively absorbing the light in the mode of the peak wavelength of the optical gain distribution of the active layer.

Specifically, the DFB laser device 40' includes a 1-$\mu$m-thick n-InP buffer layer 44', a 5-nm-thick InGaAs selective absorption layer 45A, a 100-nm-thick n-InP spacer layer 45B, MQW-SCH active layers 46', a 100-nm-thick p-InP spacer layer 48', a diffraction grating 50' including a 30-nm-thick GaInAsP layer having a period A of 240 nm, and a p-InP first cladding layer 52' having the diffraction grating 50' buried therein. The elements of the diffraction grating 50' may extend along the entire length of the active layer 46', or may extend along a portion of the length of the active layer 46' as shown by the phantom elements in Figure 6. As with the embodiment of Figure 1, these layers are epitaxially grown on an n-InP substrate 42' in succession by an MOCVD or similar method. The selective absorption layer 45A is a "quantized" structure which, for purposes of this invention, means the thickness of the selective absorption layer 45A is reduced to a size on the order of quantum mechanical wavelengths of electrons to develop the quantum effect. The thickness of selective absorption layer 45A is controlled so that the absorption edge wavelength (equivalent to bandgap wavelength) falls at a desired wavelength as will be further described below.

A top portion of the n-InP substrate 42', and the constituents of the laminated structure, i.e., the n-InP buffer layer 44', the selective absorption layer 45A, the n-InP spacer layer 45B, the active layer 46', the p-InP spacer layer 48', the diffraction grating 50', and the p-InP first cladding layer 52' having the diffraction grating 50' buried therein, are etched into mesa stripes so that the active layer 46' has a width of approximately 1.5 $\mu$m. Then, current block structures each including a p-InP layer 54' and an n-InP layer 56' are formed on both sides of the mesa stripes. Furthermore, the semiconductor laser device 40' has a 2-$\mu$m-thick p-InP second cladding layer 58' and a heavily doped p-GaInAs contact layer 60' over the first InP cladding layer 52' and the n-InP layer 56'. The laser device of the second embodiment also includes a p-side electrode 62' including a Ti/Pt/Au laminated metal film over the contact layer 60', and an n-side electrode 64' made of AuGeNi on the bottom surface of the substrate 42'. As with the first embodiment, the semiconductor laser device 40' includes a light emission facet having a reflectivity of 10-30% and a light reflecting facet of 90%.

As with the embodiment of Figures 1 and 2 of the present invention, it will be understood by one of ordinary skill in the art that the second embodiment of the present invention shown in Figures 5 and 6 is exemplary only and the compositions, film thicknesses, and the like of the compound semiconductor layers may be changed without deviating from the principles of the present invention. For example, while embodiment of Figures 5 and 6 shows the selective absorption layer 45A opposed to the diffraction grating across the active layer, it may be arranged on the same side as the diffraction grating. Although, it is noted that the opposite side arrangement has a higher degree of flexibility in design since the distance from the active layer can be arbitrarily selected. In addition, while the selective absorption layer 45A is shown as a single layer in Figures 5 and 6, multiple-quantum-well layers may be formed to achieve a greater difference in absorption coefficient as will be described below.

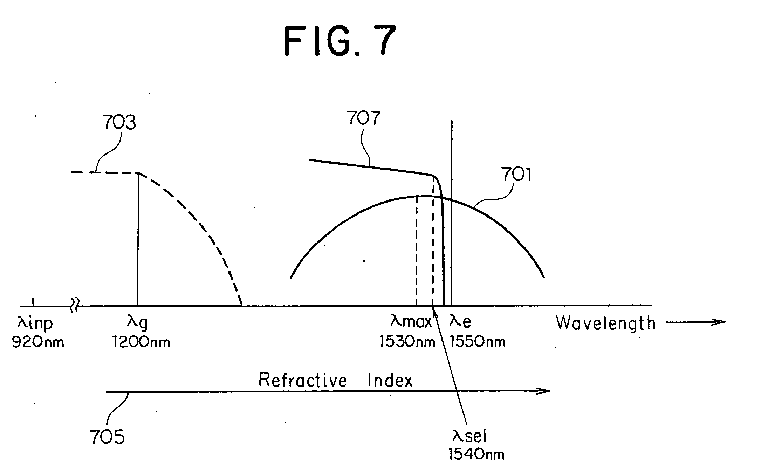

Figure 7 shows exemplary operational characteristics of a DFB laser according to the embodiment of Figures 5 and 6 of the present invention. As seen in Figure 7, the DFB laser 40' has a lasing wavelength $\lambda$e of approximately 1550 nm, the diffraction grating 50' has a bandgap wavelength $\lambda$g of approximately 1200nm, and the peak wavelength $\lambda_{max}$ of the active layer 46' is approximately 1530 nm in the optical gain distribution curve 701. Thus, the diffraction grating 50' is sufficiently transparent to the peak wavelength of the optical gain distribution of the active layer 46', and to the designed lasing wavelength of the DFB laser device 40'. In addition, a bandgap wavelength $\lambda_{sel}$ of the selective absorption layer 45A is approximately 1540 nm. Therefore the DFB laser of Figure 7 satisfies the relationship:

$$\lambda_{max} < \lambda_{sel} < \lambda e.$$

Figure 7 also depicts an absorption curve 707 of the selective absorption layer, as well as the absorption curve 703 and increasing refractive index shown by arrow 705. A complete discussion of the laser device having the selective absorption region can be found in U.S. Patent Application No. 09/906,842, the entire contents of which is incorporated herein by reference. As with the embodiment of Figure 1, the second embodiment of the present invention shown in Figures 5 and 6 provides excellent single mode operation over a wide detuning range, while having good resistance to external feedback.

The first and second embodiments of the present invention have been described above in the context of a laser device having a lasing wavelength longer than a peak wavelength of the optical gain distribution. As described in the Background section above, this provides improved operational characteristics such as high power light intensity output and current injection characteristics at higher temperatures. However, the benefits of present invention may be realized by providing a laser device of the first or second embodiment wherein the lasing wavelength $\lambda e$ is shorter than $\lambda_{max}$. This allows increased differential gain at high frequencies and provides favorable high-speed modulation characteristics for a laser device constructed according to the first and second embodiments. Moreover, as is understood by one of ordinary skill in the art, the difference in the wavelength values $\lambda e$ and $\lambda_{max}$ (i.e., detuning value) may be set to any value, limited only by the selectivity of the absorption region, to realize the benefits of the present invention. Specifically, where a steep absorption curve is achievable, the lasing wavelength $\lambda e$ may be set very close to the $\lambda_{max}$ in order to obtain a low threshold current characteristic for the laser of the first or second embodiments. Moreover, while the invention has been described with respect to a lasing wavelength of 1550nm, it is to be understood that other lasing wavelengths may be used in realizing the benefits of the present invention.

Obviously, numerous modifications and variations of the present invention are possible in light of the above teachings. It is therefore to be understood that within the scope of the appended claims, the invention may be practiced otherwise than as specifically described herein.

**Claims**

1. A semiconductor laser device comprising:

   a semiconductor substrate (12);
   an active region (16) formed on said semiconductor substrate (12) and configured to radiate light having a predetermined wavelength range;
   a light reflecting facet and a light emitting facet positioned at opposing longitudinal ends of said active region (16) to form a resonant cavity; and
   a diffraction grating (20) positioned within said resonant cavity and configured to select a first portion of said radiated light for emitting from said semiconductor laser device, **characterized by**:

   an absorption region (20) located in a vicinity of said active region (16) and configured to selectively absorb a second portion of said radiated light, wherein said first portion of said radiated light has a different wavelength than said second portion of said radiated light, and wherein said light emitting facet has a reflectivity value approximately in the range of 10% - 30%.

2. The semiconductor laser device of Claim 1, wherein said first portion of said radiated light is a single mode lasing wavelength $\lambda e$ and said second portion of said radiated light is a peak wavelength $\lambda_{max}$ of an optical gain distribution of said active region.

3. The semiconductor laser device of Claim 2, wherein said absorption region (20) is configured to provide operational characteristics satisfying the relationship:

$$0 < \lambda e - \lambda_{abs} \leq 100 \text{ nm},$$

   where $\lambda_{abs}$ is the bandgap wavelength of the absorption region, and $\lambda e$ is the single mode lasing wavelength.

4. The semiconductor laser device of Claim 3, wherein said absorption region (20) is configured to provide operational characteristics satisfying the relationship:

$$0 < \lambda e - \lambda_{abs} \leq 70 \text{ nm}.$$

5. The semiconductor laser device of Claim 2, wherein said absorption region (20) is configured to provide operational characteristics satisfying the relationship:

$$\alpha_{max} > \alpha e,$$

where $\alpha_{max}$ is an absorption coefficient with respect to the peak wavelength $\lambda_{max}$ of the optical gain distribution of the active region (16), and
$\alpha e$ is an absorption coefficient with respect to said selected lasing wavelength $\lambda e$.

6. The semiconductor laser device of Claim 5, wherein said absorption region (20) is configured to provide operational characteristics satisfying the relationship:

$$\alpha_{max} - \alpha e \geq 1 \ cm^{-1},$$

in terms of waveguide loss.

7. The semiconductor laser device of Claim 6, wherein said absorption region (20) is configured to provide operational characteristics satisfying the relationship:

$$\alpha_{max} - \alpha e \geq 5 \ cm^{-1},$$

in terms of waveguide loss.

8. The semiconductor laser device of Claim 5, wherein said absorption region is configured such that the absorption coefficient $\alpha e$ is substantially 0.

9. The semiconductor laser device of Claim 2, wherein said active region (16), wavelength selecting structure, and absorption region (20) are configured to provide operational characteristics satisfying the relationship:

$$\lambda_{abs} < \lambda_{max} < \lambda e,$$

where $\lambda_{abs}$ is the bandgap wavelength of the absorption region (20), $\lambda_{max}$ is the peak wavelength of an optical gain distribution of said active region (16), and $\lambda e$ is the single mode lasing wavelength.

10. The semiconductor laser device of Claim 2, wherein said active region (16), wavelength selecting structure, and absorption region (20) are configured to provide operational characteristics satisfying the relationship:

$$\lambda_{max} < \lambda_{abs} < \lambda e,$$

where $\lambda_{max}$ is the peak wavelength of an optical gain distribution of said active region (16), $\lambda_{abs}$ is the bandgap wavelength of the absorption region, and $\lambda e$ is the single mode lasing wavelength.

11. The semiconductor laser device of Claim 2, wherein said integrated diffraction grating (20) functions as said absorption region (20).

12. The semiconductor laser device of Claim 2, wherein said absorption region (20) comprises a selective absorption semiconductor layer.

13. The semiconductor laser device of Claim 12, wherein said selective absorption layer (20) is a quantized layer with a thickness small enough to develop a quantum effect.

14. The semiconductor laser device of Claim 13, wherein said selective absorption layer (20) has a thickness of approximately 5 nm.

15. The semiconductor laser device of Claim 1, wherein said light emitting facet has a reflectivity approximately in the range of 10% - 20%.

16. The semiconductor laser device of Claim 1, wherein said light emitting facet has a reflectivity of approximately 10%.

17. The semiconductor laser device of Claim 1, wherein said light reflecting facet has a reflectivity approximately equal to 90%.

18. A semiconductor laser device comprising:

   means (16) for radiating light having a predetermined wavelength;
   means for oscillating said radiated light within a resonator; and
   means (20) for selecting a first portion of said radiated light for emitting from said laser device, **characterized by**:

   means (20) for selectively absorbing a second portion of said radiated light, wherein said first portion of said radiated light has a different wavelength than said second portion of said radiated light.

19. The semiconductor laser device of Claim 18, wherein said means (20) for selectively absorbing comprises means for satisfying the relationship:

$$0 < \lambda e - \lambda abs \leq 100 \text{ nm},$$

   where $\lambda abs$ is a bandgap wavelength of an absorption region of the semiconductor laser device, and $\lambda e$ is the single mode lasing wavelength.

20. The semiconductor laser device Claim 18, wherein said means (20) for selectively absorbing comprises means for satisfying the relationship:

$$\alpha max > \alpha e,$$

   where $\alpha max$ is an absorption coefficient with respect to the peak wavelength $\lambda max$ of the optical gain distribution of an active region of the laser device, and $\alpha e$ is an absorption coefficient with respect to said selected lasing wavelength $\lambda e$.

21. The semiconductor laser device of Claim 20, wherein said means (20) for selectively absorbing comprises means for satisfying the relationship:

$$\alpha max - \alpha e \geq 1 \text{ cm}^{-1},$$

   in terms of waveguide loss.

22. The semiconductor laser device of Claim 20, wherein said means (20) for selectively absorbing comprises means for providing the absorption coefficient $\alpha e$ substantially at 0.

23. The semiconductor laser device of Claim 18, further comprising means for satisfying the following relationship:

$$\lambda abs < \lambda max < \lambda e,$$

   where $\lambda abs$ is the bandgap wavelength of an absorption region of the laser device, $\lambda max$ is the peak wavelength of an optical gain distribution of an active region of the laser device, and $\lambda e$ is the single mode lasing wavelength.

24. The semiconductor laser device of Claim 18, further comprising means for satisfying the following relationship:

$$\lambda max < \lambda abs < \lambda e,$$

where λmax is the peak wavelength of an optical gain distribution of and active region (16) of the laser device; λabs is the bandgap wavelength of an absorption region (20) of the laser device, and λe is the single mode lasing wavelength.

25. A semiconductor laser module comprising;
a distributed feedback (DFB) semiconductor laser device (10) comprising:

a semiconductor substrate (12),
an active region (16) formed on said semiconductor substrate (12) and configured to radiate light having a predetermined wavelength range,
a light reflecting facet and a light emitting facet positioned at opposing longitudinal ends of said active region (16) to form a resonant cavity, and
a diffraction grating (20) positioned within said resonant cavity and configured to select a first portion of said radiated light for emitting from said semiconductor laser device; and
an optical fiber coupled to said semiconductor laser device, charzacterized in that:

said DFB semiconductor laser device (10) comprises an absorption region (20) located in a vicinity of said active region (16) and configured to selectively absorb a second portion of said radiated light, wherein said first portion of said radiated light has a different wavelength than said second portion of said radiated light, and wherein said light emitting facet has a reflectivity value approximately in the range of 10% - 30%.

# FIG. I

FIG. 2

# FIG. 3A

# FIG. 3B

# FIG. 4A

20A
18
16
14
12

# FIG. 4B

P

21
23
20
18
16
14
12

# FIG. 4C

22
20
18
16
14
12

# FIG. 4D

# FIG. 4E

# FIG. 5

FIG. 6

# FIG. 7

EP 1 289 082 A2

# FIG. 8

EP 1 289 082 A2

EP 1 289 082 A2

# FIG. 9A

1403

λe − λg = 300nm

1401

λinp
920nm   λg   λmax  λe
              1550nm   Wavelength ⟶

Refractive  Index

1405

# FIG. 9B

λe − λg = −100nm

1403'

1401'

λinp
920nm   λmax  λe      λg      Wavelength ⟶
               1550nm  1650nm

Refractive  Index

1405

23